# EUROPEAN PATENT APPLICATION

(11) **EP 4 769 477 A1**
(43) Date of publication of application: **01.07.2026**
(21) Application number: 24870543.6
(22) Date of filing: 19.09.2024
(51) Int. Cl.: H01J 37/32

(54) **SEMICONDUCTOR PROCESS CHAMBER AND SEMICONDUCTOR PROCESS DEVICE**

(30) Priority: 28.09.2023 CN 202311278499
(71) Applicant: Beijing NAURA Microelectronics Equipment Co., Ltd., Beijing 100176 (CN)
(72) Inventor: KANG, Guangjie, Beijing 100176 (CN); XU, Kui, Beijing 100176 (CN); LUO, Jianheng, Beijing 100176 (CN)
(74) Representative: Cohausz & Florack
(86) International application number: PCT/CN2024/119594
(87) International publication number: WO 2025/066999

(57) **Abstract**

The present disclosure relates to the field of semiconductor technology, and more particularly to a semiconductor process chamber and semiconductor process equipment. The semiconductor process chamber includes a chamber body, a carrier, a magnetron assembly, a bias magnetic field assembly, and a magnetic shielding member. The bias magnetic field assembly is located inside the chamber body and surrounds the carrier. The magnetic shielding member is located above the bias magnetic field assembly and is configured to guide the bias magnetic field above the bias magnetic field assembly, thereby reducing the magnetic field coupling of the bias magnetic field assembly and the magnetron assembly. The semiconductor process equipment includes the above semiconductor process chamber. The semiconductor process chamber and semiconductor process equipment can reduce or even avoid the magnetic field coupling superposition of the bias magnetic field assembly and the magnetron assembly, ensuring the uniformity of plasma concentration and sputtering rate on the target surface as much as possible, reducing or even avoiding abnormal fluctuations in voltage applied to the target, and ensuring the uniformity of the corrosion depth on the target surface and the uniformity of the magnetic thin film deposited on the surface of wafer.

## Description

### TECHNICAL FIELD

The present disclosure generally relates to the field of semiconductor technology and, more particularly, to a semiconductor process chamber and semiconductor process equipment.

### BACKGROUND

With the development of semiconductor technology, the size of processors in integrated circuit manufacturing processes has been significantly reduced. However, core components such as integrated inductors and noise suppressors still face many difficulties in the process of integration and high-frequency operation. Therefore, soft magnetic thin film materials with high magnetization intensity, high permeability, and high resonance frequency are receiving increasing attention.

This magnetic thin film is usually fabricated using a magnetron sputtering deposition process. For example, in a magnetron sputtering chamber, a bias magnetic field-induced deposition method is adopted to create a magnetic anisotropy field in-plane within the deposited soft magnetic thin film. In the sputtering process, there are two types of coupling superposition of the biased magnetic field and the magnetron magnetic field: when the horizontal components of the two magnetic fields are in the same direction, the magnetic field strength is enhanced after superposition, resulting in a higher plasma density, and more plasma will bombard the target, increasing the material sputtering rate in that area; when the horizontal components of the two magnetic fields are opposite, the magnetic field strength is weakened after superposition, resulting in a lower plasma density, and less plasma will bombard the target, reducing the material sputtering rate in that area.

Due to the two different magnetic field coupling superposition on different areas of the target surface, the rotation of the magnetron during the sputtering process causes continuous switching between the two different magnetic field coupling superposition, resulting in continuous changes in the plasma density on the target surface, thus leading to abnormal fluctuations in the voltage applied to the target during the process. Furthermore, differences in the sputtering rates across the target surface during the sputtering process can lead to uneven depressions with varying corrosion depths on the target surface. This not only affects the lifespan of the target and increases production costs, but also results in poor uniformity of the magnetic thin film deposited on the wafer surface.

### SUMMARY

The present disclosure provides a semiconductor process chamber and semiconductor process equipment to solve the technical problems of differences in the sputtering rates across the target surface and poor uniformity of the deposited magnetic thin film during the sputtering process.

The semiconductor process chamber provided in the present disclosure includes:
a chamber body;
a carrier configured to carry a wafer;
a magnetron assembly disposed above the carrier;
a bias magnetic field assembly, disposed within the chamber body and surrounding the carrier; and
a magnetic shielding member disposed above the bias magnetic field assembly, configured to guide the magnetic field of the bias magnetic field assembly to reduce the magnetic field coupling of the bias magnetic field assembly and the magnetron assembly.

In some embodiments, the downward projection area of the magnetic shielding member can completely cover the bias magnetic field assembly.

In some embodiments, the magnetic shielding member is mainly made of magnetic material.

In some embodiments, the semiconductor process chamber also includes a fixation assembly, which is fixed within the space enclosed by the inner wall of the chamber body, and the bias magnetic field assembly is fixed to the fixation assembly.

In some embodiments, the fixation assembly includes an upper fixation plate and a lower fixation plate that are fixed together, the lower fixation plate is fixed within the space enclosed by the inner wall of the chamber body, the bias magnetic field assembly is fixed between the upper fixation plate and the lower fixation plate, and the magnetic shielding member is located above the upper fixation plate;
or, the fixation assembly includes a lower fixation plate, the lower fixation plate is fixed within the space enclosed by the inner wall of the chamber body, the bias magnetic field assembly is fixed to the upper surface of the lower fixation plate, and the magnetic shielding member is located above the bias magnetic field assembly;
or, the fixation assembly includes an upper fixation plate, the upper fixation plate is fixed within the space enclosed by the inner wall of the chamber body, the bias magnetic field assembly is located between the upper fixation plate and the chamber body, and the magnetic shielding member is located above the upper fixation plate.

In some embodiments, the semiconductor process chamber further includes a liner assembly, the liner assembly covering the inner wall of the chamber body, and an accommodation space is formed between the outer wall of the liner assembly and the inner wall of the chamber body;
the bias magnetic field assembly is fixed in the accommodation space, and the magnetic shielding member is located in the accommodation space or in the space enclosed by the inner wall of the liner assembly; or, both the bias magnetic field assembly and the magnetic shielding member are fixed in the space enclosed by the inner wall of the liner assembly.

In some embodiments, the inner wall of the liner assembly forms a stepped space, and the radial dimensions of the stepped space decrease sequentially from top to bottom;
the lower end of the liner assembly extends into the gap between the periphery of the carrier and the chamber body.

In some embodiments, the semiconductor process chamber further includes a shielding ring, the shielding ring having an annular body, the lower end of the annular body having a first protrusion and a second protrusion extending downwards at intervals, the first protrusion and the second protrusion being arranged sequentially inward along the radial direction;
a radial dimension of an inner ring of the annular body is smaller than a radial dimension of an outer edge of an upper surface of the carrier, and the inner ring of the annular body is located above the carrier;
the lower end of the liner assembly includes an upward-facing groove, the first protrusion is inserted into the groove, and the second protrusion is inserted into a gap between an outer wall of the groove and an outer peripheral wall of the carrier.

In some embodiments, the lower end of the annular body further includes a third protrusion extending downwards, the first protrusion, the second protrusion, and the third protrusion are arranged sequentially inward along the radial direction, the axial dimension of the third protrusion is smaller than the axial dimension of the second protrusion, and the part of the third protrusion closer to the carrier has an inclined surface, the inclined surface is inclined outward along the radial direction from top to bottom, and the inclined surface is configured to define the relative position of the carrier and the annular body.

In some embodiments, the semiconductor process chamber further includes a heat insulation ring, the heat insulation ring being placed above the shielding ring.

The semiconductor process chamber provided in present disclosure has the following beneficial effects:
In the present disclosure, taking the sputtering process as an example, since the magnetic shielding member is located above the bias magnetic field assembly, the magnetic shielding member can guide the bias magnetic field above the bias magnetic field assembly, thereby reducing the range of the magnetic field above the bias magnetic field assembly. This can weaken or even avoid the magnetic field coupling superposition of the bias magnetic field and the magnetron magnetic field, thus ensuring the uniformity of the plasma concentration and sputtering rate on the target surface as much as possible, reducing or even avoiding abnormal fluctuations in the voltage applied to the target, ensuring the uniformity of the corrosion depth on the target surface, that is, reducing or even avoiding the formation of depressions with varying corrosion depths on the target surface, ensuring the service life of the target, reducing production costs, and ensuring the uniformity of the magnetic thin film deposited on the wafer surface.

The semiconductor process equipment provided in the present disclosure includes the above-mentioned semiconductor process chamber.

The semiconductor process equipment provided in the present disclosure has the following beneficial effects:
Since this semiconductor process equipment includes the above-mentioned semiconductor process chamber, it has all the beneficial effects of the above-mentioned semiconductor process chamber, which will not be repeated here.

### BRIEF DESCRIPTION OF THE DRAWINGS

In order to more clearly illustrate the technical solutions in the embodiments of the present disclosure or the existing technology, the drawings for the description of the embodiments or the existing technology will be briefly introduced below. Obviously, the drawings in the following description are merely embodiments of the present disclosure, and for those skilled in the art, other drawings can be obtained based on the provided drawings without creative effort.
FIGs. 1a-1b schematically show the coupling superposition of the bias magnetic field and the magnetron magnetic field in related technologies;
FIG. 1c schematically shows the voltage for depositing magnetic thin film in FIGs. 1a-1b;
FIG. 1d schematically shows the corrosion depth on the surface of the target in FIGs. 1a-1b;
FIG. 1e schematically shows the thickness of the magnetic thin film deposited on the wafer surface in FIGs. 1a-1b;
FIG. 2a schematically shows a cross-sectional view of one structural form of a semiconductor process chamber and semiconductor process equipment in the present disclosure;
FIG. 2b schematically shows an enlarged view of part F in FIG. 2a;
FIG. 3a schematically shows a cross-sectional view of another structural form of a semiconductor process chamber and semiconductor process equipment in the present disclosure;
FIG. 3b schematically shows an enlarged view of part G in FIG. 3a;
FIG. 4a schematically shows a cross-sectional view of another structural form of a semiconductor process chamber and semiconductor process equipment in the present disclosure;
FIG. 4b schematically shows an enlarged view of part H in FIG. 4a;
FIGs. 5a-5b schematically show the coupling superposition of the bias magnetic field and the magnetron assembly magnetic field in the present disclosure;
FIG. 6 schematically shows the voltage for depositing a magnetic thin film in the present disclosure;
FIG. 7 schematically shows the corrosion depth on the surface of the target in the present disclosure;
FIG. 8 schematically shows the thickness of the magnetic thin film deposited on the wafer surface in the present disclosure.

### Reference numerals:

100 - Chamber body; 110 - Accommodation space;
200 - Carrier;
310 - Bias magnetic field assembly; 320 - Fixation assembly; 321 - Upper fixation plate; 322 - Lower fixation plate;
400 - Magnetic shielding member;
500 - Liner assembly; 510 - Groove;
600 - Shielding ring;
610 - Annular body; 620 - First protrusion; 630 - Second protrusion; 640 - Third protrusion;
700 - Heat insulation ring;
800 - Magnetron assembly; 810 - Target; 820 - Motor; 830 - Deionized water;
900 - Wafer; 910 - Magnetic thin film.

### DETAILED DESCRIPTION OF THE EMBODIMENTS

The details of technical solutions of the present disclosure will be described below with reference to the accompanying drawings. Obviously, the described embodiments are only some embodiments of the present disclosure, not all of them. Based on the described embodiments, all other embodiments obtained by those skilled in the art without making creative efforts are within the scope of the present disclosure.

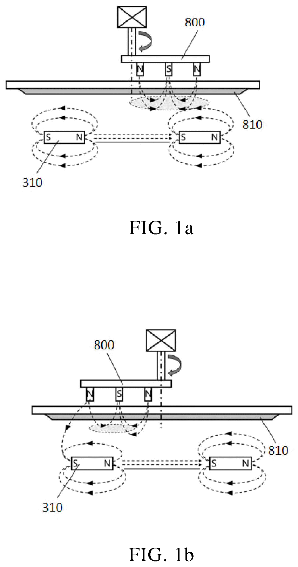

As shown in FIGs. 1a-1e, in the related sputtering process technology, a bias magnetic field is set. The bias magnetic field is a horizontal magnetic field parallel to the surface of the carrier (i.e., the carrying surface), so that when sputtering deposition of magnetic materials, the magnetic field of the magnetic material is aligned in the horizontal direction, forming an easy magnetization field in this direction, and a hard magnetization field in the direction perpendicular to this direction in the plane, thus forming an in-plane anisotropic magnetic field, resulting in an in-plane anisotropic magnetic thin film. In the sputtering process, as shown in FIGs. 1a-1b, there are two magnetic fields: one formed by the magnetron assembly 800 on the surface of the target 810, and another formed by the bias magnetic field assembly 310 on the surface of the target 810. Only the magnetic field parallel to the surface of the target 810 in the chamber will confine the electrons in the plasma. Both the magnetron assembly 800 and the bias magnetic field assembly 310 have horizontal magnetic field components on the surface of the target 810. As shown in FIG. 1a, when the horizontal components of the two magnetic fields are in the same direction, the magnetic field strength is enhanced after the superposition of the two magnetic fields, resulting in a higher plasma density. This causes more ions (e.g., Ar⁺) in the plasma to bombard the target, increasing the sputtering rate in this region. Similarly, as shown in FIG. 1b, when the horizontal components of the two magnetic fields are in opposite directions, the magnetic field strength is weakened after the superposition of the two magnetic fields, resulting in a lower plasma density. This causes fewer ions (e.g., Ar⁺) in the plasma to bombard the target, reducing the sputtering rate in this region.

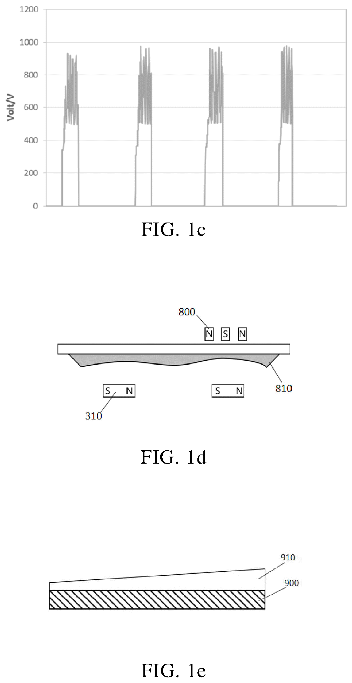

Due to the different coupling superposition of the two magnetic fields on the target surface, the rotation of the magnetron during the process causes the coupling effect of the two magnetic fields in the chamber to continuously switch, resulting in continuous changes in the plasma density on the target surface. This leads to abnormal fluctuations in the voltage applied to the target during the process, as shown in FIG. 1c. When the voltage fluctuates abnormally, the machine may trigger an alarm, preventing the process from being completed. Furthermore, the differences in the sputtering rates across the target surface cause depressions with varying depths, as shown in FIG. 1d, affecting the lifespan of the target 810 and increasing production costs. In addition, on the surface of the wafer 900, the magnetic film layer 910 deposited below the region where the magnetic field superposition is enhanced is thicker, while the magnetic film layer 910 deposited below the region where the magnetic field superposition is weakened is thinner, resulting in poor uniformity of the deposited magnetic thin film, as shown in FIG. 1e.

In the present disclosure, to address the technical problems of abnormal voltage fluctuations caused by the superposition of magnetic fields, uneven target corrosion depth, and poor uniformity of the deposited magnetic thin film, a magnetic shielding member 400 is provided above the bias magnetic field assembly 310. This magnetic shielding member 400 can guide the bias magnetic field above the bias magnetic field assembly 310, thereby weakening or even avoiding the adverse effects of the coupling superposition of the bias magnetic field and the magnetron magnetic field, as described in detail below.

The present disclosure will be further described in detail below through specific embodiments and in conjunction with the accompanying drawings.

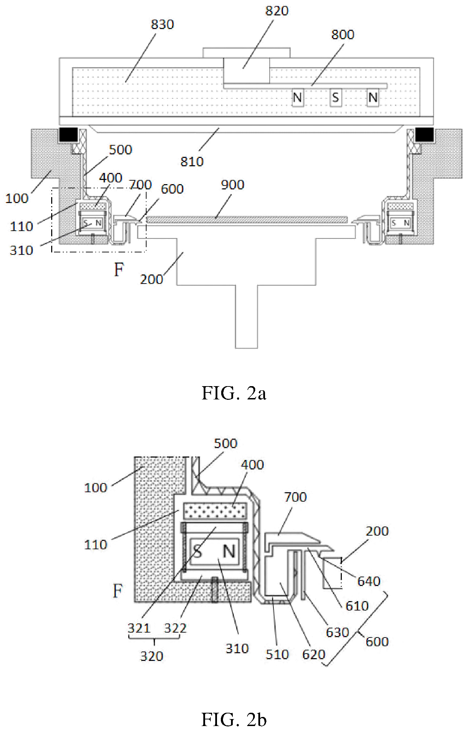

The present disclosure provides a semiconductor process chamber, taking the magnetron sputtering process as an example, as shown in FIGs. 2a-2b, 3a-3b, and 4a-4b. The semiconductor process chamber includes: a chamber body 100, a carrier 200, a magnetron assembly 800, a bias magnetic field assembly 310, and a magnetic shielding member 400. The carrier 200 is configured to carry the wafer 900; the bias magnetic field assembly 310 is fixed inside the chamber body 100 and surrounds the carrier 200; the magnetic shielding member 400 is located above the bias magnetic field assembly 310 and is configured to guide the bias magnetic field of the bias magnetic field assembly 310 to reduce the magnetic field coupling of the bias magnetic field assembly 310 and the magnetron assembly 800.

In the present disclosure, during the process, the bias magnetic field of the bias magnetic field assembly 310 forms a horizontal magnetic field on the surface of the wafer 900, so that the magnetic material sputtered onto the surface of the wafer 900 has in-plane anisotropic field, thereby obtaining an in-plane anisotropic magnetic thin film 910. The magnetic shielding member 400 is located above the bias magnetic field assembly 310, and the magnetic shielding member 400 can guide the bias magnetic field above the bias magnetic field assembly 310, thereby reducing the magnetic field range above the bias magnetic field assembly 310. This means that the magnetic field above the bias magnetic field assembly 310 is guided through the magnetic shielding member 400 as much as possible, thus increasing the distance between the bias magnetic field above the bias magnetic field assembly 310 and the magnetic field of the magnetron assembly 800 in the semiconductor process chamber. In this way, during the sputtering process, the magnetic field coupling of the bias magnetic field assembly 310 and the magnetron assembly 800 can be weakened or even avoided, thereby ensuring the uniformity of the plasma concentration and sputtering rate on the surface of the target 810, reducing or even avoiding abnormal fluctuations in the voltage applied to the target 810, ensuring the uniformity of the corrosion depth on the surface of the target 810, that is, reducing or avoiding the formation of depressions with varying corrosion depths on the surface of the target 810, ensuring the service life of the target 810, reducing production costs, and ensuring the uniformity of the magnetic thin film 910 deposited on the surface of the wafer 900.

Specifically, the carrier 200 includes a base for carrying the wafer 900. The bias magnetic field assembly 310 may include a magnet fixed within the chamber body 100 and located on the outer periphery of the carrier 200, i.e., surrounding the outer wall of the base; the magnetic shielding member 400 is located within the bias magnetic field range above the bias magnetic field assembly 310 and close to the bias magnetic field assembly 310. This can minimize the magnetic field range of the bias magnetic field above the bias magnetic field assembly 310, thereby further weakening the magnetic field coupling of the bias magnetic field assembly 310 and the magnetron assembly 800.

Consistent with the present disclosure, the magnetic shielding member 400 is mainly made of magnetic material. Any magnetic material that has no impact on the chamber and process results can be used, such as 410 stainless steel; the shape of the magnetic shielding member 400 can be a ring or an arc structure. The present disclosure does not specify any limitations on the thickness or radial width of the magnetic shielding member 400, as long as the magnetic shielding member 400 provides effective magnetic shielding and does not interfere with other components within the chamber. For example, in the present disclosure, the magnetic shielding member 400 has a thickness of 8 mm and a radial width of 28 mm. Further, there is a magnetic attraction between the magnetic shielding member 400 and the bias magnetic field assembly 310. This magnetic attraction can fix the magnetic shielding member 400 and the bias magnetic field assembly 310 together, so there is no need to set up a separate fixation structure; of course, setting a fixation structure between the magnetic shielding member 400 and the bias magnetic field assembly 310 to make their relative position more stable is also within the scope of the present disclosure.

Consistent with the present disclosure, as shown in FIGs. 2a-2b, 3a-3b, and 4a-4b, the downward projection area of the magnetic shielding member 400 can cover the bias magnetic field assembly 310. This allows for guiding the magnetic field over a larger area above the bias magnetic field assembly 310 as much as possible. Specifically, for example, the magnetic shielding member 400 can be a ring-shaped flat plate structure.

Consistent with the present disclosure, as shown in FIGs. 2a-2b, 3a-3b, and 4a-4b, a fixation assembly 320 can also be provided. The fixation assembly 320 is fixed within the space enclosed by the inner wall of the chamber body 100, and the bias magnetic field assembly 310 is fixed to the fixation assembly 320. For example, the fixation assembly 320 includes a mounting part for fixing and installing the bias magnetic field assembly 310 to ensure the installation stability of the bias magnetic field assembly 310.

Consistent with the present disclosure, as shown in FIGs. 2a-2b, the fixation assembly 320 includes an upper fixation plate 321 and a lower fixation plate 322 that are fixed together. The lower fixation plate 322 is fixed within the space enclosed by the inner wall of the chamber body 100. Specifically, the upper fixation plate 321 and the lower fixation plate 322 are fixed together by fasteners, which can be bolts or screws. The space between the upper fixation plate 321 and the lower fixation plate 322 forms a mounting part for fixing and installing the bias magnetic field assembly 310, i.e., the bias magnetic field assembly 310 is fixed between the upper fixation plate 321 and the lower fixation plate 322, and the magnetic shielding member 400 is located above the upper fixation plate 321. The material of the upper fixation plate and lower fixation plate is not limited in the present disclosure, as long as it does not adversely affect the semiconductor process chamber and the process results. The present disclosure takes stainless steel as an example.

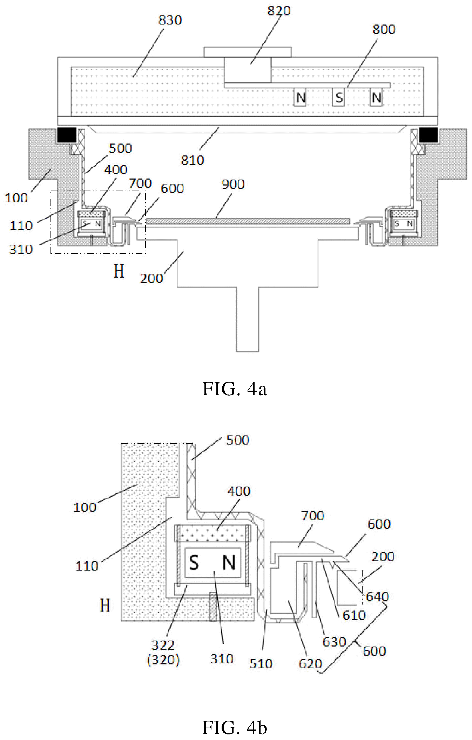

Regarding the arrangement of the fixation assembly 320 and the magnetic shielding member 400, in addition to the arrangement described above, other arrangements can also be adopted and are described in detail below.
For example, the fixation assembly 320 mainly includes a lower fixation plate 322, as shown in FIGs. 4a-4b. The lower fixation plate 322 is fixed within the space enclosed by the inner wall of the chamber body 100. The bias magnetic field assembly 310 is fixed on the upper surface of the lower fixation plate 322, and the magnetic shielding member 400 is located above the bias magnetic field assembly 310. In this case, the mounting part can be arranged on the upper surface of the lower fixation plate 322, and the bias magnetic field assembly 310 is fixed between the magnetic shielding member 400 and the lower fixation plate 322;
As another example, the fixation assembly 320 mainly includes an upper fixation plate 321 (this example is not shown in the figure). The upper fixation plate 321 is fixed within the space enclosed by the inner wall of the chamber body 100. The bias magnetic field assembly 310 is located between the upper fixation plate 321 and the chamber body 100, and the magnetic shielding member 400 is located above the upper fixation plate 321; in this case, the mounting part can be arranged on the lower surface of the upper fixation plate 321, and the bias magnetic field assembly 310 is fixed between the upper fixation plate 321 and the inner bottom wall of the chamber body 100;
Therefore, the arrangement of the fixation assembly 320 and the magnetic shielding member 400 is not limited in the present disclosure. The arrangement is acceptable as long as the magnetic shielding member 400 is located above the bias magnetic field assembly 310, capable of shielding the bias magnetic field assembly 310 from top to bottom, and the magnetic shielding member 400 is within the bias magnetic field range above the bias magnetic field assembly 310. The effect is better if the magnetic shielding member 400 is positioned as close as possible to the bias magnetic field assembly 310.

Consistent with the present disclosure, as shown in FIGs. 2a-2b, 3a-3b, and 4a-4b, the semiconductor process chamber can also be provided with a liner assembly 500. The liner assembly 500 covers the inner wall of the chamber body 100, and there is an accommodation space 110 between the outer wall of the liner assembly 500 and the inner wall of the chamber body 100. The relative positions of the bias magnetic field assembly 310 and the magnetic shielding member 400 with respect to the accommodation space 110 are as follows:
For example, the bias magnetic field assembly 310 can be fixed within the accommodation space 110. This arrangement allows the liner assembly 500 to prevent magnetic material sputtered from the target 810 from being deposited on the inner wall of the chamber body 100 and above the bias magnetic field assembly 310, thus avoiding affecting the performance of the bias magnetic field assembly 310. When the bias magnetic field assembly 310 is fixed within the accommodation space 110, the magnetic shielding member 400 can also be arranged within the accommodation space 110, further, the fixation assembly 320 can be fixed within the accommodation space 110. For example, when the fixation assembly 320 includes the lower fixation plate 322 but not the upper fixation plate 321, the side wall of the liner assembly 500, the magnetic shielding member 400, the bias magnetic field assembly 310, the lower fixation plate 322, and the side wall of the chamber body 100 are arranged sequentially from top to bottom; when the fixation assembly 320 includes the upper fixation plate 321 but not the lower fixation plate 322, the side wall of the liner assembly 500, the magnetic shielding member 400, the upper fixation plate 321, the bias magnetic field assembly 310, and the side wall of the chamber body 100 are arranged sequentially from top to bottom; when the fixation assembly 320 includes both the upper fixation plate 321 and the lower fixation plate 322, the side wall of the liner assembly 500, the magnetic shielding member 400, the upper fixation plate 321, the bias magnetic field assembly 310, the lower fixation plate 322, and the side wall of the chamber body 100 are arranged sequentially from top to bottom.

When the bias magnetic field assembly 310 is fixed within the accommodation space 110, the magnetic shielding member 400 can also be arranged in the space enclosed by the inner wall of the liner assembly 500. In this case, the magnetic shielding member 400 is located outside the accommodation space 110, and the fixation assembly 320 is fixed within the accommodation space 110. For example, when the fixation assembly 320 includes the lower fixation plate 322 but not the upper fixation plate 321, the magnetic shielding member 400, the side wall of the liner assembly 500, the bias magnetic field assembly 310, the lower fixation plate 322, and the side wall of the chamber body 100 are arranged sequentially from top to bottom; when the fixation assembly 320 includes the upper fixation plate 321 but not the lower fixation plate 322, the magnetic shielding member 400, the side wall of the liner assembly 500, the upper fixation plate 321, the bias magnetic field assembly 310, and the side wall of the chamber body 100 are arranged sequentially from top to bottom; when the fixation assembly 320 includes both the upper fixation plate 321 and the lower fixation plate 322, the magnetic shielding member 400, the side wall of the liner assembly 500, the upper fixation plate 321, the bias magnetic field assembly 310, the lower fixation plate 322, and the side wall of the chamber body 100 are arranged sequentially from top to bottom.

As another example, the bias magnetic field assembly 310 and the magnetic shielding member 400 can both be fixed in the space enclosed by the inner wall of the liner assembly 500. In this case, both the bias magnetic field assembly 310 and the magnetic shielding member 400 are located outside the accommodation space 110. In this case, the fixation assembly 320 is fixed in the space enclosed by the inner wall of the liner assembly 500, i.e., outside the accommodation space 110. For example, when the fixation assembly 320 includes the lower fixation plate 322 but not the upper fixation plate 321, the magnetic shielding member 400, the bias magnetic field assembly 310, the lower fixation plate 322, the side wall of the liner assembly 500, and the side wall of the chamber body 100 are arranged sequentially from top to bottom; when the fixation assembly 320 includes the upper fixation plate 321 but not the lower fixation plate 322, the magnetic shielding member 400, the upper fixation plate 321, the bias magnetic field assembly 310, the side wall of the liner assembly 500, and the side wall of the chamber body 100 are arranged sequentially from top to bottom; when the fixation assembly 320 includes both the upper fixation plate 321 and the lower fixation plate 322, the magnetic shielding member 400, the upper fixation plate 321, the bias magnetic field assembly 310, the lower fixation plate 322, the side wall of the liner assembly 500, and the side wall of the chamber body 100 are arranged sequentially from top to bottom.

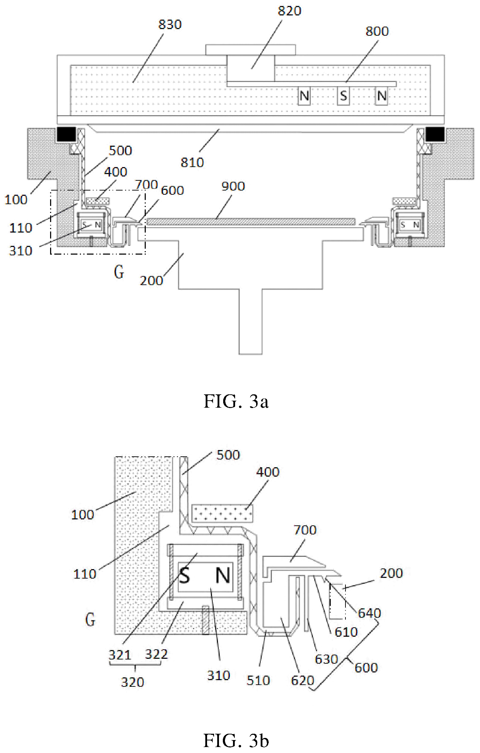

In the embodiments of the present disclosure, as shown in FIGs. 2a-2b and 4a-4b, the magnetic shielding member 400 can be arranged inside the accommodation space 110 and above the bias magnetic field assembly 310. This arrangement prevents magnetic material sputtered from the target 810 from being deposited on the magnetic shielding member 400, thus avoiding affecting the magnetic permeability of the magnetic shielding member 400. In some embodiments, as shown in FIGs. 3a-3b, the magnetic shielding member 400 can be arranged within the space enclosed by the inner wall of the liner assembly 500, that is, above the accommodation space 110 and outside the accommodation space 110, within the space enclosed by the inner wall of the liner assembly 500. With this arrangement, the magnetic shielding member 400 can still guide the magnetic field above the bias magnetic field assembly 310, at least partially mitigating the adverse effects of the coupling superposition of the magnetic fields of the magnetron assembly 800 and the bias magnetic field assembly 310. However, the magnetic material sputtered from the target 810 may fall onto the magnetic shielding member 400, which may affect the magnetic permeability of the magnetic shielding member 400.

It should be noted that the connection method between the upper fixation plate and lower fixation plate and the chamber body can be achieved using fasteners such as bolts, screws, and pins; the connection method between the upper fixation plate and lower fixation plate and the liner assembly can be achieved using fasteners such as bolts, screws, and pins; the connection method between the upper fixation plate and lower fixation plate can be achieved using fasteners such as bolts, screws, and pins. The connection methods are not limited in the present disclosure, and any method that achieves the corresponding connection relationship is within the scope of the present disclosure.

As shown in FIGs. 2a-2b, 3a-3b, and 4a-4b, the specific structure of the liner assembly 500 is not limited in the present disclosure, for example, the liner assembly 500 can be configured into a structure such that its inner wall forms a stepped space, and the radial dimension of this stepped space decreases from top to bottom. The lower end of the liner assembly 500 extends into the gap between the outer periphery of the carrier 200 and the chamber body 100 to seal this gap. With this arrangement, the accommodation space 110 can be formed by the lower surface of the step of the liner assembly 500, the outer side wall of the liner assembly 500 below this lower surface, the inner side wall of the lower end of the chamber body 100, and the inner bottom wall of the chamber body 100. When the bias magnetic field assembly 310 is placed in the accommodation space 110, and the magnetic shielding member 400 is placed in the space enclosed by the inner wall of the liner assembly 500, the magnetic shielding member 400 can be arranged on the upper surface of the step of the liner assembly 500. Furthermore, the lower end of the liner assembly 500 extends into the gap between the outer periphery of the carrier 200 and the chamber body 100 to seal this gap, preventing magnetic material sputtered from the target 810 from leaking through this gap.

Consistent with the present disclosure, as shown in FIGs. 2a-2b, 3a-3b, and 4a-4b, the semiconductor process chamber can also be provided with a shielding ring 600. The shielding ring 600 has an annular body 610, and the lower end of the annular body 610 includes a first protrusion 620 and a second protrusion 630 extending downwards at intervals. The first protrusion 620 and the second protrusion 630 are arranged sequentially inward along the radial direction (i.e., from the outer ring to the inner ring of the annular body 610). The radial dimension of the inner ring of the annular body 610 is smaller than the radial dimension of the outer edge of the upper end surface of the carrier 200, and the inner ring of the annular body 610 is located above the carrier 200. The lower end of the liner assembly 500 has an upward-facing groove 510. The first protrusion 620 is inserted into the groove 510, and the second protrusion 630 is inserted into the gap between the outer side wall of the groove 510 and the outer peripheral wall of the carrier 200. With this arrangement, the annular body 610 can seal the gap between the lower end of the liner assembly 500 and the outer peripheral wall of the carrier 200, preventing magnetic material sputtered from the target 810 from leaking through this gap. The first protrusion 620, the second protrusion 630, and the groove 510 are interlocked, which can determine the relative position between the annular body 610 and the liner assembly 500 in the radial direction. During the process, the carrier 200 can come into contact with the shielding ring 600 after being moved up. At this time, the bias magnetic field of the bias magnetic field assembly 310 will form a horizontal magnetic field on the surface of the wafer 900, so that the magnetic material sputtered onto the wafer surface has an in-plane anisotropic field, thereby obtaining an in-plane anisotropic magnetic thin film.

Specifically, the annular body 610 can adopt an annular plate-like structure, and the first protrusion 620 and the second protrusion 630 can be columnar protrusions or cylindrical shell structures. The radial thickness of the first protrusion 620 can be set to match the radial width of the groove 510, minimizing the gap between the outer edge of the annular body 610 and the inner wall of the lower end of the liner assembly 500, to reduce or even prevent magnetic material sputtered from the target 810 from falling into the groove 510; the distance between the first protrusion 620 and the second protrusion 630 can be set to match the wall thickness of the groove 510 for further radial positioning.

Consistent with the present disclosure, as shown in FIGs. 2a-2b, 3a-3b, and 4a-4b, the lower end of the annular body 610 extends downward with a third protrusion 640. The first protrusion 620, the second protrusion 630, and the third protrusion 640 are arranged sequentially inward along the radial direction (i.e., from the outer ring to the inner ring of the annular body 610). That is, compared to the second protrusion 630, the third protrusion 640 is closer to the carrier 200. The axial dimension of the third protrusion 640 is smaller than the axial dimension of the second protrusion 630, and the part of the third protrusion 640 closer to the carrier 200 has an inclined surface. The inclined surface slopes radially outward from top to bottom, and the inclined surface is configured to define the relative position of the carrier 200 and the annular body 610. It should be noted that the axial dimension here refers to the dimension extending downward from the lower end of the annular body 610 in the vertical direction. Based on this, the inclined surface of the third protrusion 640 closer to the carrier 200 extends and slopes radially outward from top to bottom. This arrangement not only defines the relative position between the annular body 610 and the carrier 200, but the inclined surface also serves as a guiding function.

Consistent with the present disclosure, as shown in FIGs. 2a-2b, 3a-3b, and 4a-4b, the semiconductor process chamber also includes a heat insulation ring 700 positioned above the shielding ring 600. The heat insulation ring 700 effectively insulates heat, preventing the high temperatures generated during the process from causing deformation of the shielding ring 600. Specifically, the shielding ring 600 and the heat insulation ring 700 are detachably connected, for example, by snap-fitting. For instance, one of them has a slot, and the other has a corresponding latch. As shown in FIGs. 2a-2b, 3a-3b, and 4a-4b, the outer edge of the upper surface of the shielding ring 600 has a downward-facing notch forming a slot with the inner wall of the liner assembly 500. The lower end of the outer edge of the heat insulation ring 700 extends downward to form a protruding part acting as a latch. The protruding part of the heat insulation ring 700 is snapped into the notch of the shielding ring 600, thus preventing radial displacement between the shielding ring 600 and the heat insulation ring 700.

Consistent with the present disclosure, the bias magnetic field assembly 310 includes magnets. The magnets can be configured as columnar structures, with their axes along the radial direction of the carrier 200, i.e., the columnar magnets are placed horizontally. There are multiple magnets, arranged sequentially along the circumferential direction of the chamber body 100. There can be various specific arrangements of the magnets. For example, multiple magnets are arranged in a set, with each group of magnets arranged sequentially along the circumferential direction of the chamber body 100, forming an annular sector region. Multiple sets of magnets are provided, and the multiple sets of magnets are uniformly or symmetrically arranged along the circumferential direction of the chamber body 100 or the carrier 200. For example, two sets of magnets are provided, and they are axially symmetrical or centrally symmetrical with respect to the axis of the chamber body 100.

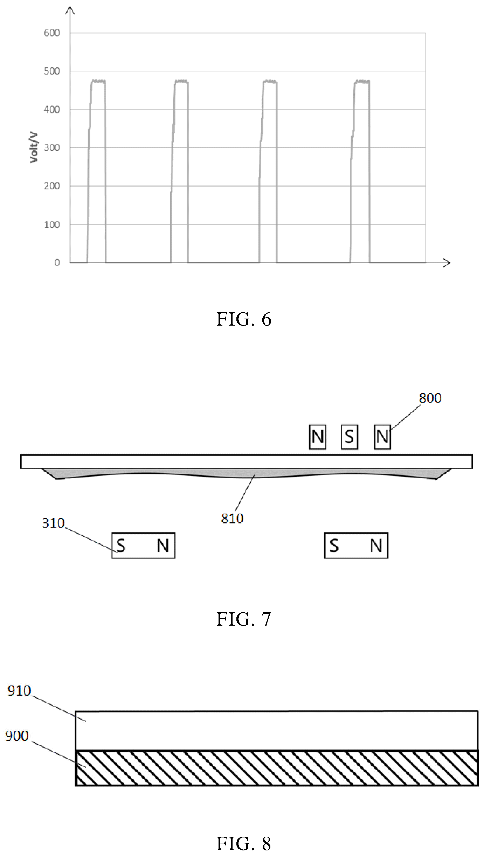

As described above, consistent with the present disclosure, a magnetic shielding member 400 is provided in the process chamber for depositing magnetic thin films, as shown in FIGs. 2a-2b, 3a-3b, and 4a-4b. Since the magnetic shielding member 400 is capable of magnetic guiding, placing the magnetic shielding member 400 in the bias magnetic field range above the bias magnetic field assembly 310 allows the magnetic field lines to pass through the magnetic shielding member 400 from the N pole back to the S pole, reducing the magnetic field range above the bias magnetic field assembly 310. In this way, the magnetic field on the surface of the wafer 900 in the horizontal direction will not be affected, and the magnetic field coupling superposition of the bias magnetic field above the bias magnetic field assembly 310 and the magnetic field of the magnetron assembly 800 on the surface of the target 810 can also be weakened, reducing or even avoiding the influence of the magnetron rotation in the magnetron assembly 800 on the plasma density on the surface of the target 810, and reducing or even avoiding abnormal fluctuations in the voltage applied to the target during the process. As shown in FIG. 6, the voltage applied to the target tends to be stable. Furthermore, the corrosion depth on the surface of the target 810 is essentially uniform, as shown in FIG. 7. This can improve the utilization rate of the target and reduce costs, and also improve the problem of poor uniformity of the magnetic thin film 910 deposited on the surface of the wafer 900, as shown in FIG. 8, resulting in a magnetic thin film 910 with better uniformity on the surface of the wafer 900.

The present disclosure also provides semiconductor process equipment, including the above-mentioned semiconductor process chamber. Since the semiconductor process equipment includes the above-mentioned semiconductor process chamber, the semiconductor process equipment has all the beneficial effects of the above-mentioned semiconductor process chamber, which will not be repeated here.

Consistent with the present disclosure, a target 810 and a motor 820 for driving the magnetron assembly 800 to rotate are provided above the semiconductor process chamber.

Consistent with the present disclosure, a lifting drive mechanism (not shown in the figure) can also be provided, and the lifting drive mechanism is drivingly connected to the magnetron assembly 800. This lifting drive mechanism is configured to drive the magnetron assembly 800 to move up and down, thereby adjusting the distance between the magnetic field of the magnetron assembly 800 and the bias magnetic field of the bias magnetic field assembly 310. For example, increasing the distance between the two magnetic fields can reduce the adverse effects caused by the magnetic field coupling superposition of the two magnetic fields.

Consistent with the present disclosure, a cover is provided above the semiconductor process chamber for containing deionized water 830.

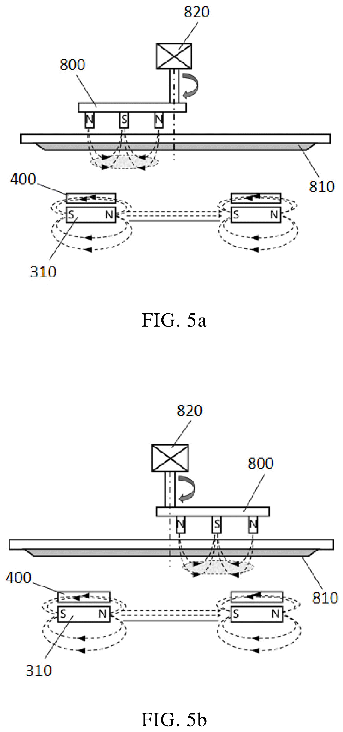

Consistent with the present disclosure, during the sputtering process, as shown in FIGs. 2a-2b, 3a-3b, and 4a-4b, the magnetron assembly 800 rotates above the target 810 under the drive of the motor 820, and the target 810 is cooled by deionized water 830 in the area where the magnetron assembly 800 is located. Due to the magnetic shielding member 400 is capable of magnetic guiding, as shown in FIGs. 2a-2b, 3a-3b, and 4a-4b, and 5a-5b, the magnetic shielding member 400 can guide the bias magnetic field above the bias magnetic field assembly 310 from the N pole back to the S pole, thereby reducing the range of the magnetic field above the bias magnetic field assembly 310. In this way, the magnetic field on the surface of the wafer 900 in the horizontal direction will not be affected, and the magnetic field coupling superposition of the bias magnetic field above the bias magnetic field assembly 310 and the magnetic field of the magnetron assembly 800 on the surface of the target 810 can also be weakened, reducing or even avoiding the influence of the rotation of the magnetron assembly 800 on the plasma density on the surface of the target 810, and reducing or even avoiding abnormal fluctuations in the voltage applied to the target during the process, as shown in FIG. 6, where the voltage applied to the target tends to be stable. In addition, the corrosion depth on the surface of the target 810 is essentially uniform, as shown in FIG. 7, which can improve the utilization rate of the target and reduce costs. At the same time, this can also improve the problem of poor uniformity of the magnetic thin film 910 deposited on the surface of the wafer 900, as shown in FIG. 8, resulting in a magnetic thin film 910 with better uniformity on the surface of the wafer 900.

In the present disclosure, it should be noted that the terms "upper," "lower," "front," "horizontal," etc., indicating orientation or positional relationships are based on the orientation or positional relationships shown in the drawings, and are merely for the convenience of describing the present disclosure and simplifying the description, and are not intended to indicate or imply that the device or element referred to must have a specific orientation, or be constructed and operated in a specific orientation, and therefore should not be understood as a limitation on the present disclosure.

In the present disclosure, it should be noted that, unless otherwise explicitly specified and defined, the term "connect" should be understood broadly, for example, it can be a fixed connection, a detachable connection, or an integral connection; it can be a mechanical connection or an electrical connection; it can be directly connected or indirectly connected through an intermediate medium, or it can be a connection within two components. For those skilled in the art, the specific meaning of the above terms in the present disclosure can be understood according to actual needs.

It should be noted that the above embodiments are merely used to illustrate the technical solutions of the present disclosure, and not to limit them; although the present disclosure has been described in detail with reference to the above embodiments, those skilled in the art should understand that they can still modify the technical solutions described in the foregoing embodiments, or make equivalent substitutions for some or all of the technical features; and these modifications or substitutions do not cause the essence of the corresponding technical solutions to deviate from the scope of the technical solutions of the embodiments of the present disclosure.

## Claims

1. A semiconductor process chamber comprising:
a chamber body;
a carrier configured to carry a wafer;
a magnetron assembly disposed above the carrier;
a bias magnetic field assembly, disposed within the chamber body and surrounding the carrier; and
a magnetic shielding member disposed above the bias magnetic field assembly, configured to guide the magnetic field of the bias magnetic field assembly to reduce magnetic field coupling of the bias magnetic field assembly and the magnetron assembly.

2. The semiconductor process chamber according to claim 1, wherein a downward projection area of the magnetic shielding member completely covers the bias magnetic field assembly.

3. The semiconductor process chamber according to claim 1, wherein the magnetic shielding member is mainly made of magnetic material.

4. The semiconductor process chamber according to claim 1, further comprising: a fixation assembly, the fixation assembly being fixed within the space enclosed by an inner wall of the chamber body, and the bias magnetic field assembly being fixed to the fixation assembly.

5. The semiconductor process chamber according to claim 4, wherein the fixation assembly includes an upper fixation plate and a lower fixation plate fixed together, the lower fixation plate being fixed within a space enclosed by the inner wall of the chamber body, the bias magnetic field assembly being fixed between the upper fixation plate and the lower fixation plate, and the magnetic shielding member being located above the upper fixation plate;
or, the fixation assembly includes a lower fixation plate, the lower fixation plate being fixed within a space enclosed by the inner wall of the chamber body, the bias magnetic field assembly being fixed to an upper surface of the lower fixation plate, and the magnetic shielding member being located above the bias magnetic field assembly;
or, the fixation assembly includes an upper fixation plate, the upper fixation plate being fixed within a space enclosed by the inner wall of the chamber body, the bias magnetic field assembly being disposed between the upper fixation plate and the chamber body, and the magnetic shielding member being located above the upper fixation plate.

6. The semiconductor process chamber according to any one of claims 1-5, further comprising: a liner assembly, the liner assembly covering an inner wall of the chamber body, and an accommodation space is provided between an outer wall of the liner assembly and the inner wall of the chamber body;
the bias magnetic field assembly is fixed within the accommodation space, and the magnetic shielding member is located within the accommodation space or within a space enclosed by an inner wall of the liner assembly; or, both the bias magnetic field assembly and the magnetic shielding member are fixed within the space enclosed by the inner wall of the liner assembly.

7. The semiconductor process chamber according to claim 6, wherein the inner wall of the liner assembly forms a stepped space, and radial dimensions of the stepped space decreases sequentially from top to bottom;
a lower end of the liner assembly extends into a gap between a periphery of the carrier and the chamber body.

8. The semiconductor process chamber according to claim 7, further comprising a shielding ring having an annular body, a lower end of the annular body having a first protrusion and a second protrusion extending downwards at intervals, the first protrusion and the second protrusion being arranged sequentially inward along a radial direction;
a radial dimension of an inner ring of the annular body is smaller than a radial dimension of an outer edge of an upper surface of the carrier, and the inner ring of the annular body is located above the carrier;
the lower end of the liner assembly includes an upward-facing groove, the first protrusion is inserted into the groove, and the second protrusion is inserted into a gap between an outer wall of the groove and an outer peripheral wall of the carrier.

9. The semiconductor process chamber according to claim 8, wherein the lower end of the annular body further includes a third protrusion extending downwards, the first protrusion, the second protrusion, and the third protrusion being arranged sequentially inward along the radial direction, an axial dimension of the third protrusion being smaller than an axial dimension of the second protrusion, and a part of the third protrusion closer to the carrier includes an inclined surface, the inclined surface slopes radially outward from top to bottom, and the inclined surface is configured to define a relative position of the carrier and the annular body.

10. The semiconductor process chamber according to claim 8 or 9, further comprising a heat insulation ring, the heat insulation ring being disposed above the shielding ring.

11. Semiconductor process equipment comprising a semiconductor process chamber according to any one of claims 1-10.
